# EUROPEAN PATENT APPLICATION

(11) **EP 4 472 378 A1**
(43) Date of publication of application: **04.12.2024**
(21) Application number: 23769922.8
(22) Date of filing: 17.03.2023
(51) Int. Cl.: H10B 41/35

(54) **THREE-DIMENSIONAL MEMORY AND PREPARATION METHOD THEREFOR, STORAGE SYSTEM, AND ELECTRONIC DEVICE**

(30) Priority: 18.03.2022 CN 202210270254
(71) Applicant: Yangtze Memory Technologies Co., Ltd., Wuhan, Hubei 430000 (CN)
(72) Inventor: ZHANG, Zhong, Wuhan, Hubei 430000 (CN); WANG, Di, Wuhan, Hubei 430000 (CN); ZHOU, Wenxi, Wuhan, Hubei 430000 (CN); XIA, Zhiliang, Wuhan, Hubei 430000 (CN); HUO, Zongliang, Wuhan, Hubei 430000 (CN)
(74) Representative: Gramm, Lins & Partner Patent- und Rechtsanwälte PartGmbB
(86) International application number: PCT/CN2023/082249
(87) International publication number: WO 2023/174420

(57) **Abstract**

The present disclosure provides a three-dimensional memory and a fabrication method thereof, a memory system, and an electronic apparatus, and relates to the technical field of semiconductor chips. The three-dimensional memory includes a stack structure, an etch stop layer, a protective layer, and a plurality of connection pillars. The stack structure includes a gate layer and a dielectric layer disposed alternately and a plurality of steps. The etch stop layer is disposed on the steps. The protective layer covers the stack structure and the etch stop layer. The connection pillar penetrates through the protective layer and the etch stop layer on a corresponding step and is electrically connected with the gate layer of the corresponding step.

## Description

### CROSS-REFERENCE TO RELATED APPLICATIONS

The present disclosure is filed based on China Patent Application No. 202210270254.X filed on March 18, 2022, and claims priority to the China Patent Application, which is incorporated by reference herein in its entirety.

### TECHNICAL FIELD

The present disclosure relates to the technical field of semiconductor chips, and particularly to a three-dimensional memory and a fabrication method thereof, a memory system, and an electronic apparatus.

### BACKGROUND

As a feature size of a memory cell approaches a lower limit of a process, the planar process and manufacturing technology become challenging and costly, causing a storage density of a 2D or planar NAND flash to approach an upper limit. In order to overcome limitations caused by the 2D or planar NAND flash, the industry has developed a memory with a three-dimensional structure (3D NAND), in which memory cells are arranged on a substrate three-dimensionally to increase the storage density.

In the 3D NAND, a memory array device comprises an array area and a step area. During fabrication of the memory array device, a contact hole is formed at each step of the step area by means of etching, and is filled with a conductive material to form a connection pillar, thereby leading in or out an electrical signal of a gate layer.

However, during the etching for forming the contact hole, the gate layer may be etched through, such that the contact hole passes through a dielectric layer between two adjacent ones of gate layers, leading to shorting between different gate layers, i.e., shorting between word lines of different layers, thereby generating a control error to the memory cell and causing a storage failure.

### SUMMARY

Examples of the present disclosure provide a three-dimensional memory and a fabrication method thereof, a memory system, and an electronic apparatus.

The examples of the present disclosure employ the following technical solutions:
In an aspect, a three-dimensional memory is provided. The three-dimensional memory comprises a stack structure, an etch stop layer, a protective layer, and a plurality of connection pillars. The stack structure comprises a gate layer and a dielectric layer disposed alternately. The stack structure comprises a plurality of steps. The etch stop layer is disposed on the steps. The protective layer covers the stack structure and the etch stop layer. Each step corresponds to at least one connection pillar, and the connection pillar penetrates through the protective layer and the etch stop layer on the corresponding step and is electrically connected with the gate layer of the corresponding step.

In some examples, the etch stop layer comprises a plurality of etch stop portions, one of the etch stop portions is provided on each of the steps, and the plurality of etch stop portions are disposed as being spaced apart from each other.

In some examples, the etch stop layer is a continuous film layer covering the plurality of steps.

In some examples, a material of the etch stop layer comprises an insulation material.

In some examples, the three-dimensional memory further comprises a first dielectric layer and a second dielectric layer, the first dielectric layer is disposed around the gate layer, and the second dielectric layer is disposed around the etch stop layer.

In some examples, the three-dimensional memory further comprises an isolation structure. The isolation structure penetrates through the stack structure and the protective layer and comprises a first insulation layer, wherein a material of the first insulation layer is different from that of the etch stop layer.

In some examples, the isolation structure further comprises a filling layer, and the first insulation layer is located between the filling layer and the stack structure.

In some examples, the material of the etch stop layer comprises silicon nitride or polysilicon.

In some examples, the three-dimensional memory further comprises an isolation structure penetrating through the stack structure and the protective layer and comprising a second insulation layer, wherein a material of the second insulation layer is the same as that of the etch stop layer.

In some examples, the isolation structure further comprises a filling layer, and the second insulation layer is located between the filling layer and the stack structure.

In some examples, the isolation structure further comprises a third insulation layer located between the filling layer and the second insulation layer.

In some examples, the material of the first insulation layer and the etch stop layer comprises silicon nitride.

In some examples, a thickness of the etch stop layer is greater than a thickness of the gate layer.

In another aspect, a fabrication method of a three-dimensional memory is provided. The fabrication method comprises: forming an initial stack structure comprising a first sacrificial layer and a dielectric layer disposed alternately and comprising a plurality of initial steps; forming a second sacrificial layer on the initial stack structure; forming a gate line slit penetrating through the second sacrificial layer and the initial stack structure, and removing the first sacrificial layer to form a first cavity and removing the second sacrificial layer to form a second cavity through the gate line slit; forming a gate layer in the first cavity; forming an etch stop layer in the second cavity; and forming an isolation structure in the gate line slit.

In some examples, after forming the second sacrificial layer on the initial stack structure, the fabrication method further comprises: patterning the second sacrificial layer to form a plurality of sacrificial portions, wherein one of the sacrificial portions is provided on each of the initial steps, and the plurality of sacrificial portions are disposed as being spaced apart from each other.

In some examples, the forming the gate layer in the first cavity and forming the etch stop layer in the second cavity comprise: filling the first cavity with a gate material and filling the second cavity partially with the gate material through the gate line slit; removing the gate material in the second cavity; and forming the etch stop layer in the second cavity.

In some examples, the forming the etch stop layer in the second cavity comprises: filling the second cavity with a dielectric material through the gate line slit. The dielectric material in the second cavity forms the etch stop layer.

In some examples, the forming the etch stop layer in the second cavity comprises: filling the second cavity with a semiconductor material through the gate line slit; and removing the semiconductor material covering a sidewall of the gate line slit, to form the etch stop layer.

In some examples, before forming the gate layer in the first cavity and forming the etch stop layer in the second cavity, the fabrication method further comprises: forming a first dielectric layer in the first cavity, and forming a second dielectric layer in the second cavity, wherein the first dielectric layer covers a sidewall of the first cavity, and the second dielectric layer covers a sidewall of the second cavity.

In some examples, the fabrication method further comprises: forming a protective layer covering the initial stack structure and the second sacrificial layer, wherein the gate line slit also penetrates through the protective layer.

In some examples, the fabrication method further comprises: forming a plurality of initial contact holes penetrating through the protective layer; etching the etch stop layer exposed by the initial contact hole, to form a contact hole; and filling the contact hole with a conductive material to form a connection pillar, wherein the connection pillar is electrically connected with the gate layer of the corresponding step.

In still another aspect, a memory system is provided. The memory system comprises a controller and a three-dimensional memory, wherein the three-dimensional memory is the three-dimensional memory as described in any one of the above examples or fabricated by the fabrication method of a three-dimensional memory as described in any one of the above examples, and the controller is coupled to the three-dimensional memory to control the three-dimensional memory to store data.

In yet another aspect, an electronic apparatus is provided. The electronic apparatus comprises the memory system as described in any one of the above examples.

### BRIEF DESCRIPTION OF THE DRAWINGS

In order to illustrate the technical solutions in the present disclosure more clearly, the drawings to be used in some examples of the present disclosure will be briefly introduced below. Apparently, the drawings in the following description are only drawings of some examples of the present disclosure. Those of ordinary skills in the art may also obtain other drawings according to these drawings. In addition, the drawings in the following description may be regarded as schematic diagrams, instead of limitations to an actual size of a product, an actual flow of a method, an actual timing of a signal, etc. involved in the examples of the present disclosure.
FIG. 1 is a perspective view of a structure of a three-dimensional memory provided according to some examples;
FIG. 2 is a top view of the three-dimensional memory provided according to some examples;
FIG. 3 is a cross-sectional view along AA' of the three-dimensional memory shown in FIG. 2;
FIG. 4 is an equivalent circuit diagram of a memory cell string of the three-dimensional memory in FIG. 1;
FIG. 5 is a cross-sectional view along a first direction of a step area of the three-dimensional memory provided according to some examples;
FIG. 6 is a cross-sectional view along the first direction of the step area of another three-dimensional memory provided according to some examples;
FIG. 7 is a cross-sectional view along a second direction of the step area of the three-dimensional memory provided according to some examples;
FIG. 8 is a cross-sectional view along the second direction of the step area of another three-dimensional memory provided according to some examples;
FIG. 9 is a flow diagram of a fabrication method of a three-dimensional memory according to some examples;
FIG. 10 is a diagram of a fabrication operation of the fabrication method of a three-dimensional memory according to some examples;
FIGs. 11, 24, 25, 28, and 31 are flow diagrams of the fabrication method of a three-dimensional memory according to some examples;

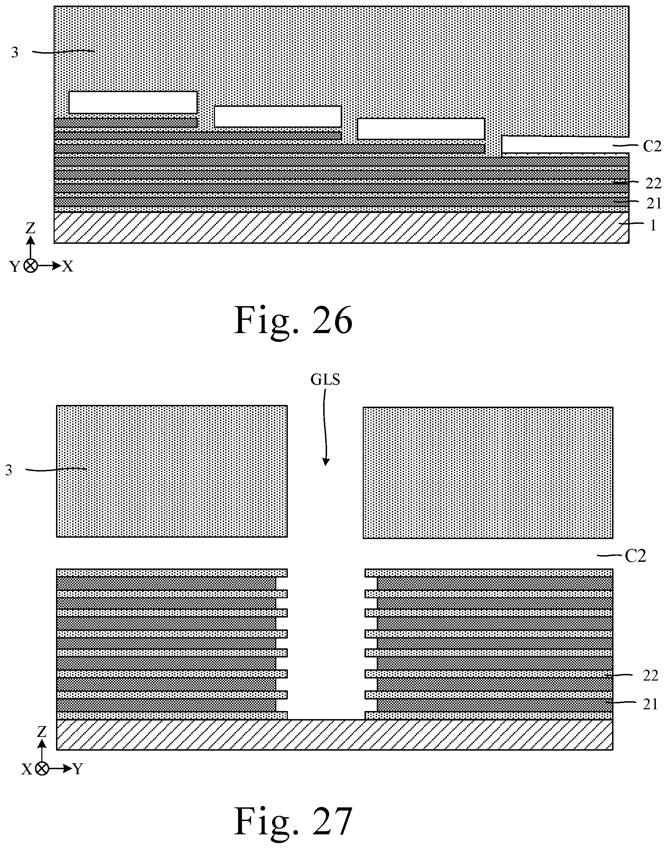

FIGs. 12-23, 26, 27, 29, 30, 32, and 33 are diagrams of fabrication operations of the fabrication method of a three-dimensional memory according to some examples;
FIG. 34 is a structural diagram of the three-dimensional memory according to some examples;
FIG. 35 is a block diagram of a memory system according to some examples; and
FIG. 36 is a block diagram of the memory system according to some other examples.

### DETAILED DESCRIPTION

The technical solutions in some examples of the present disclosure will be described below clearly and completely in conjunction with the drawings. Apparently, the examples described are only part of, but not all of, the examples of the present disclosure. All other examples obtained by those of ordinary skills in the art based on the examples provided by the present disclosure should fall within the scope of protection of the present disclosure.

In the description of the present disclosure, it is to be understood that the terms "center", "upper", "lower", "front", "rear", "left", "right", "vertical", "horizontal", "top", "bottom", "inner", "outer", etc. indicate orientations or position relationships that are based on the orientations or position relationships as shown in the drawings, and are only intended to facilitate description of the present disclosure and to simplify the description, instead of indicating or implying that a device or an element indicated must have a specific orientation or be constructed and operated in a specific orientation, and thus cannot be understood as limiting the present disclosure.

Unless otherwise specified in the context, throughout the specification and the claims, the term "comprise" is interpreted as an open and inclusive meaning, i.e., "including, but not limited to". In the description of the specification, the terms "one implementation", "some implementations", "an implementation", "one example", or "some examples", etc. are intended to indicate that particular features, structures, materials, or characteristics related to the implementation or example are included in at least one implementation or example of the present disclosure. The schematic representation of the above terms may not necessarily refer to the same implementation or example. Furthermore, the particular features, structures, materials, or characteristics may be included in any one or more implementation or examples in any suitable manner.

In the following, the terms "first" and "second" are only for the purpose of description, and cannot be construed as indicating or implying relative importance or implicitly indicating the number of indicated technical features. Thus, features defined by "first" and "second" may explicitly or implicitly comprise one or more of such features. In the description of the examples of the present disclosure, "a plurality of' means two or more, unless otherwise stated.

In describing some examples, expressions of "connected" and derivatives thereof may be used. For example, the term "connected" may be used in the description of some examples to indicate that two or more components have a direct physical contact or an electrical contact with each other. The examples disclosed herein are not necessarily limited to the content herein.

"At least one of A, B, and C" and "at least one of A, B, or C" have the same meaning, both comprising the following combinations of A, B, and C: only A, only B, only C, a combination of A and B, a combination of A and C, a combination of B and C, and a combination of A, B, and C.

"A and/or B" comprises the following three combinations: only A, only B, and a combination of A and B.

The meaning of "on", "above", and "over" in the contents of the present disclosure should be interpreted in the broadest manner such that "on" not only means "directly on something" but also comprises the meaning of "on something" with an intermediate feature or layer therebetween, and that "above" or "over" not only means "above" or "over" something but also comprises the meaning of "above" or "over" something with no intermediate feature or layer therebetween (i.e., directly on something).

Example implementations are described herein with reference to at least one of a cross-sectional view or a planar view used as an idealized example drawing. In the drawings, thicknesses of layers and areas are exaggerated for clarity. Thus, changes in shapes relative to the drawings caused by, for example, at least one of a manufacturing technology or a tolerance, may be contemplated. Therefore, the example implementations should not be interpreted as being limited to the shapes of areas shown herein, but rather comprise shape deviations caused by, for example, manufacturing. For example, an etching area shown as a rectangle will typically have a curved feature. Therefore, the areas shown in the drawings are schematic essentially, and their shapes are neither intended to show actual shapes of areas of an apparatus, nor intended to limit the scope of the example implementations.

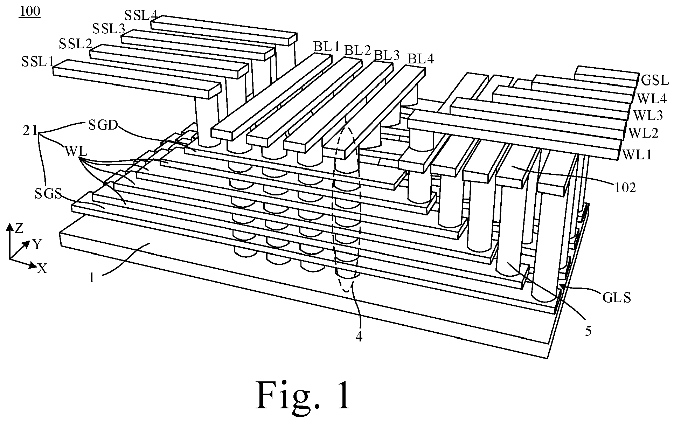

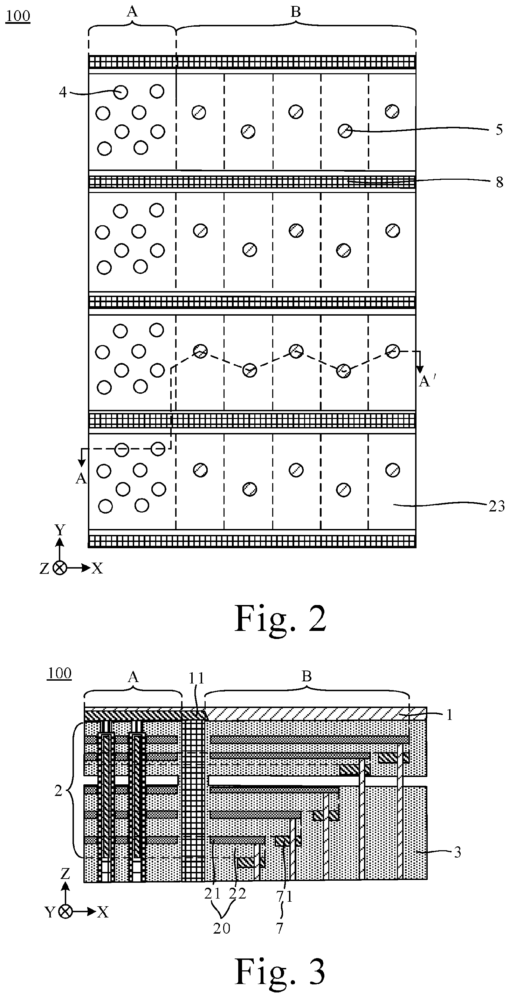

FIG. 1 is a perspective view of a structure of a three-dimensional memory 100 provided according to some examples. FIG. 2 is a top view of the three-dimensional memory 100 provided according to some examples. FIG. 3 is a cross-sectional view along AA' of the three-dimensional memory 100 shown in FIG. 2. FIG. 2 illustrates the top view of only a partial area of the three-dimensional memory 100.

With reference to FIGs. 1 and 2, the three-dimensional memory 100 comprises an array area A and a step area B. The step area B may be located between the array areas A or may be located on the periphery of the array area A. In an example, along a first direction X, the three-dimensional memory 100 comprises the array area A and the step area B disposed sequentially in juxtaposition, wherein the array area A is configured to form a memory cell, and the step area B is configured to provide a contact for connecting with a word line connection line (WL1 to WL4 are used as an example for illustration in FIG. 1).

With reference to FIGs. 1 and 3, the three-dimensional memory 100 comprises a stack structure 2 and a protective layer 3 covering the stack structure 2, wherein the stack structure 2 comprises a gate layer 21 and a dielectric layer 22 (not shown in FIG. 1) disposed alternately.

It is to be noted that the number of gate layers 21 and the number of dielectric layers 22 of the stack structure 2 may be set according to actual demands, and the present disclosure imposes no detailed limitation here.

In some examples, as shown in FIGs. 1 and 3, the three-dimensional memory 100 further comprises a substrate 1, wherein the stack structure 2 is disposed on the substrate 1.

In some examples, the substrate 1 is configured to support the stack structure 2, and may comprise a doped area 11, and a material of the substrate 1 comprises at least one of monocrystalline silicon (Si), monocrystalline germanium (Ge), a group III-V compound semiconductor material, a group II-VI compound semiconductor material, or other semiconductor materials known in the art.

In some other examples, the substrate 1 does not function to support the stack structure 2, and may be a source layer, and the material of the source layer comprises a semiconductor material. The semiconductor material, for example, may be monocrystalline silicon, polysilicon, monocrystalline germanium, a group III-V compound semiconductor material, a group II-VI compound semiconductor material, and other suitable semiconductor materials. The source layer may be doped partially or fully. In an example, the source layer may comprise a doped region that is doped with a p-type dopant.

In some examples, a material of the dielectric layer 22 comprises an insulation material. In an example, the material of the dielectric layer 22 comprises silicon oxide or silicon nitride. For example, the material of the dielectric layer 22 comprises silicon dioxide, and the present disclosure is not limited thereto.

In some examples, a material of the gate layer 21 comprises a conductive material. In an example, the material of the gate layer 21 comprises metal or doped polysilicon. For example, the material of the gate layer 21 comprises at least one of tungsten, cobalt, copper, aluminum, and doped crystalline silicon, and the present disclosure is not limited thereto.

In some examples, a material of the protective layer 3 comprises an insulation material. The material of the protective layer 3 may be the same as the material of the dielectric layer 22. In an example, the material of the protective layer 3 comprises silicon oxide or silicon nitride. For example, the material of the protective layer 3 comprises silicon dioxide, and the present disclosure is not limited thereto.

As shown in FIGs. 1, 2, and 3, there are a plurality of memory cell strings 4 in the array area A, wherein the plurality of memory cell strings 4 penetrate through the stack structure 2 along a third direction Z, and the plurality of memory cell strings 4 may be arranged in rows and columns in a first direction X and a second direction Y.

It is to be noted that the substrate 1 extends on an X-Y plane, wherein the first direction X and the second direction Y may be two orthogonal directions on the plane of the substrate 1. For example, the first direction X is an extension direction of a word line WL, the second direction Y is an extension direction of a bit line BL, and the third direction Z is perpendicular to the substrate 1, i.e., perpendicular to the X-Y plane.

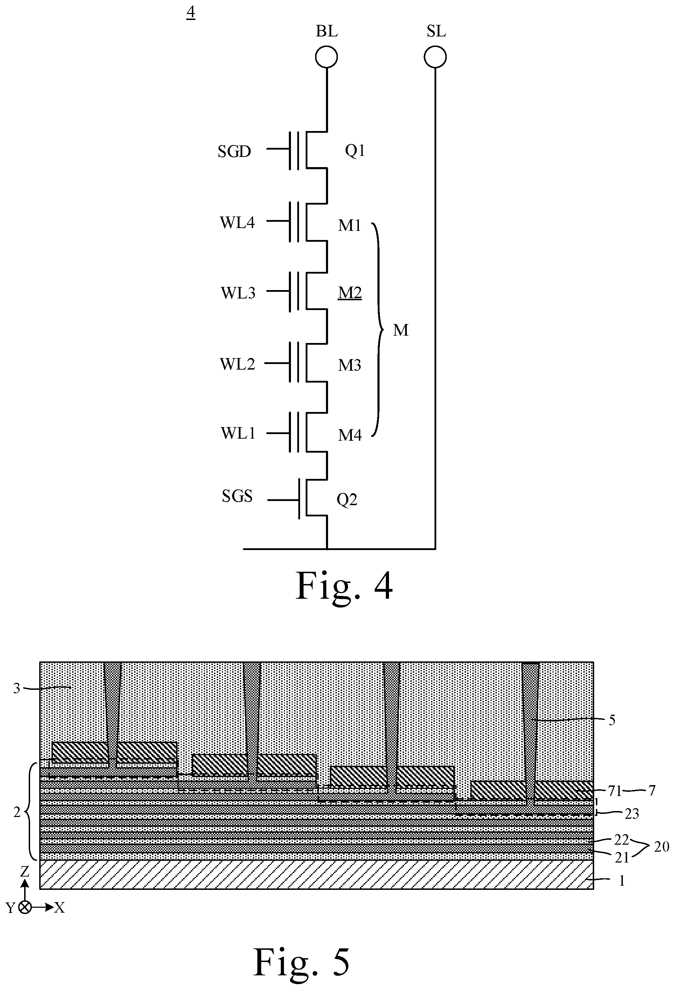

FIG. 4 is an equivalent circuit diagram of a memory cell string 4 of the three-dimensional memory 100 in FIG. 1. As shown in FIGs. 1 and 4, one memory cell string 4 is equivalent to an storage capacity of a plurality of planar memory cells. Accordingly, the three-dimensional memory 100 may provide a large storage capacity.

With reference to FIGs. 1 and 4, a first end of the memory cell string 4 is connected to the bit line BL, and a second end is connected to a source line SL. That is, the memory cell string 4 comprises a plurality of transistors connected in series between the first end and the second end, wherein the plurality of transistors comprise at least one top selection transistor Q1, at least one storage transistor M, and at least one bottom selection transistor Q2. The plurality of transistors comprising one top selection transistor Q1, four storage transistors M, and one bottom selection transistor Q2 are illustrated as an example in FIG. 4.

In a write operation, for the memory cell string 4, data is written to a selected storage transistor (one of M1 to M4 in FIG. 4) in the storage transistors M using a Fowler-Nordheim (FN) tunneling effect.

In a read operation, for the memory cell string 4, an amount of stored charge is determined according to an on state of a selected storage transistor (one of M1 to M4 in FIG. 4) in the storage transistors M, thereby obtaining data represented by the amount of charge.

FIG. 5 is a cross-sectional view along the first direction X of the step area B of the three-dimensional memory 100 provided according to some examples. As shown in FIGs. 2 and 5, a portion of the stack structure 2 in the step area B comprises a plurality of steps 23, and each gate layer 21 of the stack structure 2 is electrically connected with a corresponding signal line connection line through a connection pillar 5.

In an example, with reference to FIG. 1, along the third direction Z, at least one lowermost gate layer 21 of a plurality of gate layers 21 is constructed as a ground selection line layer SGS, and at least one uppermost gate layer 21 of a plurality of gate layers 21 is constructed as a string selection line layer SGD; and the intermediate gate layer 21 of the plurality of gate layers 21 is constructed as a word line layer WL. One gate layer 21 as being constructed as the ground selection line layer SGS (a gate of a bottom selection transistor Q2), one gate layer 21 as being constructed as a string selection line layer SGD (a gate of a top selection transistor Q1), and four gate layers as being constructed as word line layers WL (gates of the storage transistors M) are illustrated as an example in FIG. 1.

The string selection line layer SGD is electrically connected with a corresponding selection line connection line (one of SSL1 to SSL4) through the connection pillar 5, the ground selection line layer SGS is electrically connected with a ground selection line GSL through the connection pillar 5, and the word line layer WL is electrically connected with a corresponding word line connection line (one of WL1 to WL4) through the connection pillar 5.

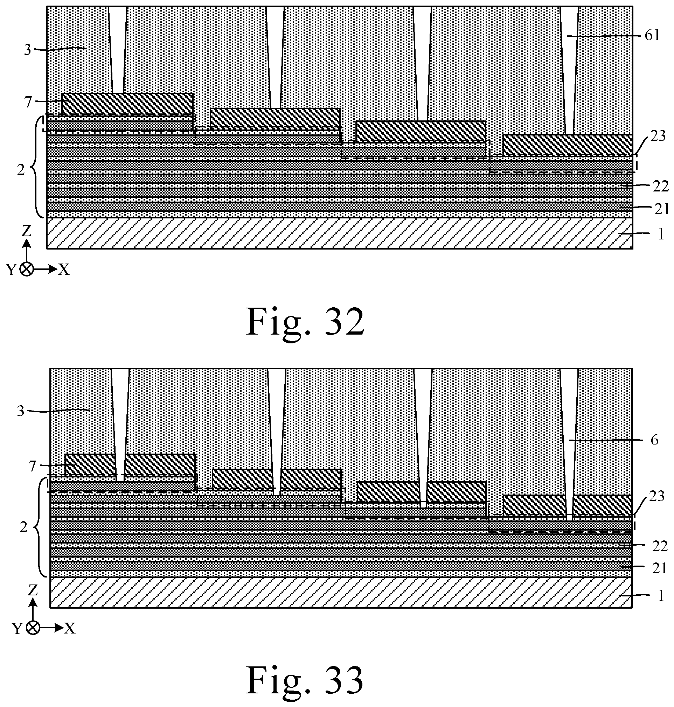

During a process of forming the connection pillar 5, the protective layer 3 covering the stack structure 2 is first etched to form the contact hole 6 (referring to FIG. 33). However, during the etching of the protective layer 3 for forming the contact hole 6, due to different thicknesses of the protective layer 3 over different steps 23, the gate layer 21 of the step 23 corresponding to the thin protective layer 3 is prone to be etched through, such that the contact hole 6 (referring to FIG. 33) passes through the dielectric layer 22 between two adjacent ones of the gate layers 21, leading to shorting between different gate layers 21, thereby generating a control error to the memory cell and causing a storage failure.

On that basis, with reference to FIGs. 3 and 5, some examples of the present disclosure provide a three-dimensional memory 100 comprising the stack structure 2, an etch stop layer 7, the protective layer 3, and a plurality of connection pillars 5.

The etch stop layer 7 is disposed on a plurality of steps 23, and the protective layer 3 covers the stack structure 2 and the etch stop layer 7. Each step 23 corresponds to at least one connection pillar 5, which penetrates through the protective layer 3 and the etch stop layer 7 on the corresponding step 23 and is electrically connected with the gate layer 21 of the corresponding step 23.

It is to be noted that the protective layer 3 has a high etch selectivity ratio with respect to the etch stop layer 7, to ensure that an initial contact hole 61 (referring to FIG. 32) may be caused to stop on the etch stop layer 7 during subsequent removal of the protective layer 3 for forming the contact hole 6 (referring to FIG. 33). It is to be understood that the initial contact hole 61 (referring to FIG. 32) may also penetrate through the protective layer 3 and extend to stop in the etch stop layer 7. In an example, the material of the protective layer 3 comprises silicon oxide, and a material of the etch stop layer 7 comprises silicon nitride. A process of removing the protective layer 3 to form the contact hole 6 (referring to FIG. 33) may be referred to a preparation method of the three-dimensional memory 100 mentioned below, which is no longer repeated here.

In the three-dimensional memory 100 provided in the above example of the present disclosure, the etch stop layer 7 is disposed on the step 23. In this case, during a process of forming the contact hole 6 (referring to FIG. 33), a via formed by etching the protective layer 3 may be stopped at the etch stop layer 7 by means of the etch stop layer 7, to form the initial contact hole 61 (referring to FIG. 32). Then, the etch stop layer 7 exposed by the initial contact hole 61 (referring to FIG. 32) is etched, wherein the etching stops at the gate layer 21 of the corresponding step 23 to form the contact hole 6 (referring to FIG. 33).

On that basis, for the three-dimensional memory 100 provided in the above example of the present disclosure, during the etching for forming the contact hole 6, the contact hole 6 (referring to FIG. 33) for forming the connection pillar 5 may be stopped at the corresponding gate layer 21 by means of two-step etching, solving the problem of shorting between different gate layers 21 resulting from the contact hole 6 etching through the gate layer 21, thereby improving a product yield.

In some examples, as shown in FIG. 5, the thickness of the etch stop layer 7 is greater than the thickness of the gate layer 21. The thickness of the etch stop layer 7 may be designed according to the thickness of the stack structure 2, and the present disclosure imposes no detailed limitation here.

In some examples, the three-dimensional memory 100 further comprises a first dielectric layer and a second dielectric layer, wherein the first dielectric layer is disposed between the gate layer 21 and the dielectric layer 22, and the second dielectric layer is disposed between the etch stop layer 7 and the dielectric layer 22, so as to reduce the risk of a leakage current of the memory cell. A material of the first dielectric layer and the second dielectric layer is a high dielectric constant material. For example, the material of the first dielectric layer and the second dielectric layer comprises at least one of aluminum oxide, hafnium oxide, and tantalum oxide.

In some examples, the three-dimensional memory 100 further comprises an adhesive layer disposed between the second dielectric layer and the gate layer 21, so as to increase the adhesion between the gate layer 21 and the second dielectric layer. A material of the adhesive layer comprises at least one of tantalum, tantalum nitride, titanium, and titanium nitride.

In some examples, as shown in FIG. 5, the etch stop layer 7 comprises a plurality of etch stop portions 71, one of the etch stop portions 71 is provided on each of the steps 23, and the plurality of etch stop portions 71 are disposed as being spaced apart from each other. That is, in two adjacent ones of the steps 23, the step 23 relatively away from the substrate 1 is a first step, the step 23 relatively close to the substrate 1 is a second step, and the etch stop portion 71 on the first step is spaced apart from the etch stop portion 71 on the second step. That is, the etch stop portions 71 on different steps 23 are separated from each other, thereby reducing a structural stress and improving reliability.

As shown in FIG. 5, the etch stop portion 71 on the second step is also spaced apart from the first step. That is, there is a gap between the etch stop portion 71 on the second step and the gate layer 21 comprised in the first step, i.e., the etch stop portion 71 is electrically insulated from the gate layer 21 comprised in the first step. In this case, the material of the etch stop portion 71 may further comprise a conductive material, the connection pillar 5 is electrically connected with only the gate layer 21 of the step 23 below it, and there is no shorting between different gate layers 21, causing no storage failure.

It is to be noted that the material of the etch stop portion 71 may comprise an insulation material or a conductive material. In an example, the material of the etch stop portion 71 comprises any one of silicon nitride, polysilicon, and metal, and the present disclosure is not limited thereto.

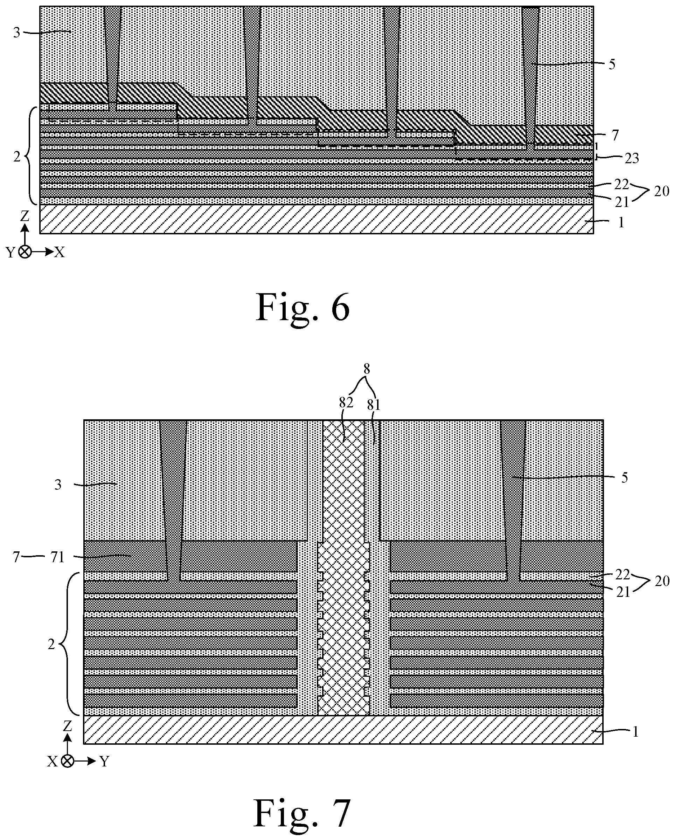

FIG. 6 is a cross-sectional view along the first direction X of the step area B of another three-dimensional memory 100 provided according to some examples. In some other examples, as shown in FIG. 6, the etch stop layer 7 is a continuous film layer covering the plurality of steps 23.

In order to avoid the shorting between different gate layers 21 which is caused by electrically connecting them through the etch stop layer 7, the material of the etch stop layer 7 is an insulation material. As such, the connection pillar 5 is electrically connected with only the gate layer 21 of the step 23 below it by direct contact, there is no shorting between different gate layers 21, causing no storage failure.

It is to be noted that when the second dielectric layer is disposed between the etch stop layer 7 and the dielectric layer 22, the second dielectric layer is also an insulation material, such as aluminum oxide, so as to avoid the shorting between different gate layers 21 which is caused by electrically connecting them through the etch stop layer 7. In this case, the continuous etch stop layer 7 may also be of a conductive material.

FIG. 7 is a cross-sectional view along the second direction Y of the step area B of a three-dimensional memory 100 provided according to some examples. As shown in FIGs. 1, 2, and 7, the three-dimensional memory 100 further comprises an isolation structure 8 penetrating through the stack structure 2 and the protective layer 3, so as to divide the three-dimensional memory 100 into a plurality of memory blocks.

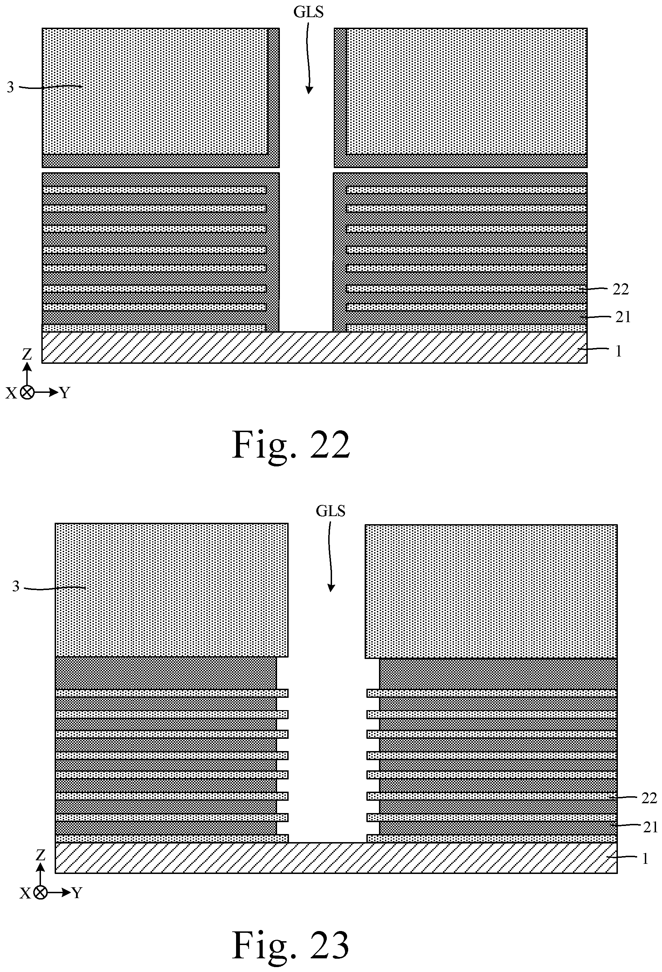

In some examples, with reference to FIGs. 7 and 23, the stack structure 2 has a gate line slit GLS, and the isolation structure 8 is located in the gate line slit GLS. The isolation structure 8 comprises a first insulation layer 81, which fills the gate line slit GLS to prevent shorting between different gate layers 21 in the gate line slit GLS, or prevent oxidization of the gate layer 21. A material of the first insulation layer 81 is different from that of the etch stop layer 7, i.e., the first insulation layer 81 and the etch stop layer 7 are formed respectively in different process operations.

In some other examples, as shown in FIGs. 7 and 23, the isolation structure 8 comprises the first insulation layer 81 and a filling layer 82, wherein the first insulation layer 81 covers a sidewall of the gate line slit GLS to prevent shorting between different gate layers 21 in the gate line slit GLS, or prevent oxidization of the gate layer 21; and the filling layer 82 fills the gate line slit GLS to provide a mechanical support function, so as to prevent collapse of the stack structure 2. The material of the first insulation layer 81 is different from that of the etch stop layer 7, i.e., the first insulation layer 81 and the etch stop layer 7 are formed respectively in different process operations. That is, there is an apparent interface distinction between the first insulation layer 81 and the etch stop layer 7.

It is to be noted that, when the etch stop layer 7 comprises a plurality of etch stop portions 71 disposed as being spaced apart, the etch stop layer 7 may be an insulation material or a conductive material. When the etch stop layer 7 is a continuous film layer, the etch stop layer 7 may be an insulation material. In an example, the etch stop layer 7 comprises silicon nitride.

Furthermore, the material of the first insulation layer 81 comprises an insulation material. In an example, the material of the first insulation layer 81 comprises silicon oxide, and the present disclosure is not limited thereto. A material of the filling layer 82 may be a conductive material or an insulation material. In an example, the material of the filling layer 82 comprises polysilicon, and the present disclosure is not limited thereto. When an array common source doped area is formed in the substrate 1 exposed by the gate line slit GLS, the material of the filling layer 82 may be a conductive material, and a source signal may be led out through the filling layer 82 disposed in the gate line slit GLS.

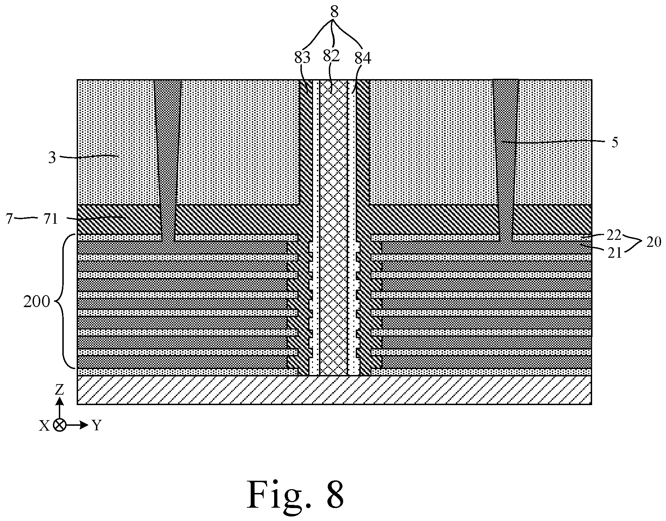

FIG. 8 is a cross-sectional view along the second direction Y of the step area B of another three-dimensional memory 100 provided according to some examples. As shown in FIGs. 1, 2, and 8, the semiconductor structure 100 further comprises the isolation structure 8 penetrating through the stack structure 2 and the protective layer 3, so as to divide the semiconductor structure 100 into a plurality of memory blocks.

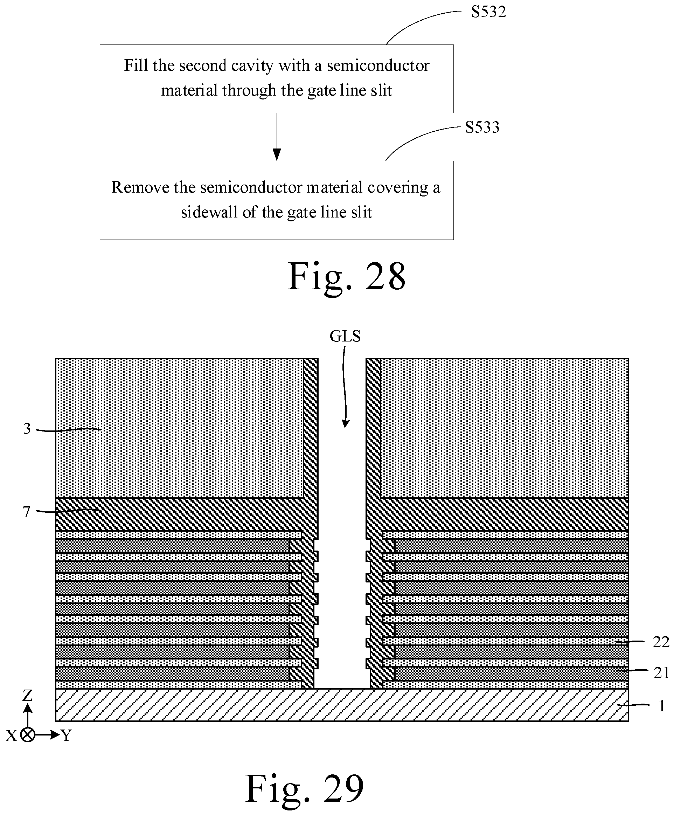

In some examples, as shown in FIGs. 8 and 29, the isolation structure 8 comprises a second insulation layer 83, which fills the gate line slit GLS to prevent shorting between different gate layers 21 in the gate line slit GLS, or prevent oxidization of the gate layer 21. A material of the second insulation layer 83 is the same as that of the etch stop layer 7, i.e., the second insulation layer 83 and the etch stop layer 7 may be formed jointly in the same process operation. That is, there is no apparent interface distinction between the second insulation layer 83 and the etch stop layer 7.

In some other examples, as shown in FIGs. 8 and 29, the isolation structure 8 comprises the second insulation layer 83, a third insulation layer 84, and the filling layer 82, wherein the second insulation layer 83 covers a sidewall of the gate line slit GLS to prevent shorting between different gate layers 21 in the gate line slit GLS, or prevent oxidization of the gate layer 21. The third insulation layer 84 is located on a side of the second insulation layer 83 away from the stack structure 2 and between the filling layer 82 and the second insulation layer 83. The filling layer 82 is located on a side of the third insulation layer 84 away from the second insulation layer 83, and fills the gate line slit GLS to provide a mechanical support function, so as to prevent collapse of the stack structure 2.

The material of the second insulation layer 83 is the same as that of the etch stop layer 7, i.e., the second insulation layer 83 and the etch stop layer 7 may be formed jointly in the same process operation. That is, there is no apparent interface distinction between the second insulation layer 83 and the etch stop layer 7. In an example, the material of the second insulation layer 83 comprises silicon nitride, and the present disclosure is not limited thereto. The material of the third insulation layer 84 comprises an insulation material. In an example, the material of the third insulation layer 84 comprises silicon oxide, and the present disclosure is not limited thereto. The material of the filling layer 82 may be referred to above and is no longer repeated here.

It is to be noted that, when the second insulation layer 83 and the etch stop layer 7 are formed jointly in the same process operation, the etch stop layer 7 is an insulation material regardless of whether the etch stop layer 7 comprises a plurality of etch stop portions 71 disposed as being spaced apart or the etch stop layer 7 is a continuous film layer. In an example, the etch stop layer 7 comprises silicon nitride.

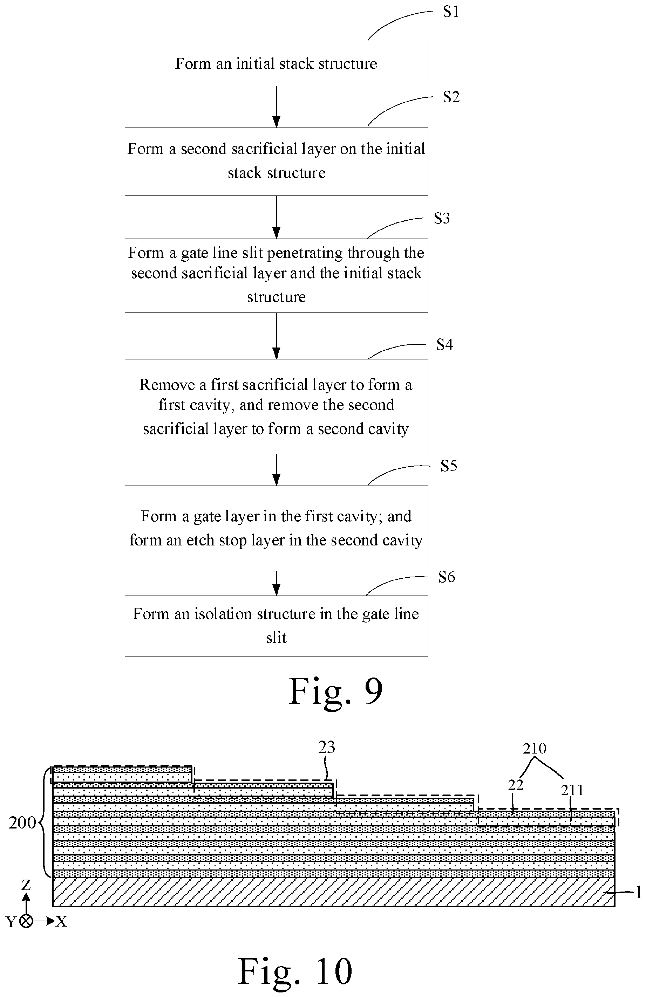

As shown in FIG. 9, some examples of the present disclosure further provide a fabrication method of the three-dimensional memory 100 (referring to FIG. 3), which comprises S1-S6.

S1: With reference to FIGs. 9 and 10, an initial stack structure 200 is formed.

In the above operation, the initial stack structure 200 comprises a first sacrificial layer 211 and the dielectric layer 22 disposed alternately. The initial stack structure 200 comprises a plurality of initial steps 23, and an uppermost layer of the initial step 23 is the dielectric layer 22.

The initial stack structure 200 may be formed by means of any one of thin film deposition processes such as chemical vapor deposition (CVD), physical vapor deposition (PVD), and atomic layer deposition (ALD). In an example, a plurality of initial film layer pairs 210 are formed sequentially on the substrate 1 using the CVD thin film deposition process, wherein each initial film layer pair 210 comprises the first sacrificial layer 211 and the dielectric layer 22 disposed sequentially.

It is to be noted that the plurality of initial steps 23 of the initial stack structure 200 may be formed by performing a plurality of times of "trim-etch" cyclic process. An area where the plurality of initial steps 23 are located may be referred to as the step area B (referring to FIG. 2).

The material of the dielectric layer 22 is different from a material of the first sacrificial layer 211. The material of the dielectric layer 22 comprises an insulation material. In an example, the material of the dielectric layer 22 comprises silicon oxide or silicon nitride. For example, the material of the dielectric layer 22 comprises silicon dioxide, and the present disclosure is not limited thereto. The material of the first sacrificial layer 211 comprises at least one of polysilicon, silicon nitride, and polycrystalline germanium, and the present disclosure is not limited thereto.

S2: With reference to FIGs. 9, 12, and 13, a second sacrificial layer 710 is formed on the initial stack structure 200.

In the above operation, the second sacrificial layer 710 is disposed on the initial step 23. The second sacrificial layer 710 may be formed by means of any one of the thin film deposition processes such as CVD, PVD, and ALD. In an example, the second sacrificial layer 710 is formed on a plurality of initial steps 23 using the PVD thin film deposition process.

It is to be noted that a material of the second sacrificial layer 710 is the same the material of the first sacrificial layer 211 and comprises at least one of polysilicon, silicon nitride, and polycrystalline germanium, and the present disclosure is not limited thereto. It is to be understood that the material of the dielectric layer 22 is also different from the material of the second sacrificial layer 710. In an example, the material of the dielectric layer 22 comprises silicon dioxide, and the material of the second sacrificial layer 710 comprises silicon nitride.

S3: With reference to FIGs. 9, 17, and 18, the gate line slit GLS penetrating through the second sacrificial layer 710 and the initial stack structure 200 is formed.

In the above operation, the gate line slit GLS may be formed by means of dry etching or a combination of dry etching and wet etching processes. In an example, the gate line slit GLS is formed using an anisotropic etching (any one of dry etching such as ion milling etching, plasma etching, reactive ion etching, laser ablation, etc.) process, and an etching duration is controlled such that the etching penetrates through the initial stack structure 200.

S4: With reference to FIGs. 9, 17, and 18, through the gate line slit GLS, the first sacrificial layer 211 is removed to form a first cavity C1, and the second sacrificial layer 710 is removed to form a second cavity C2.

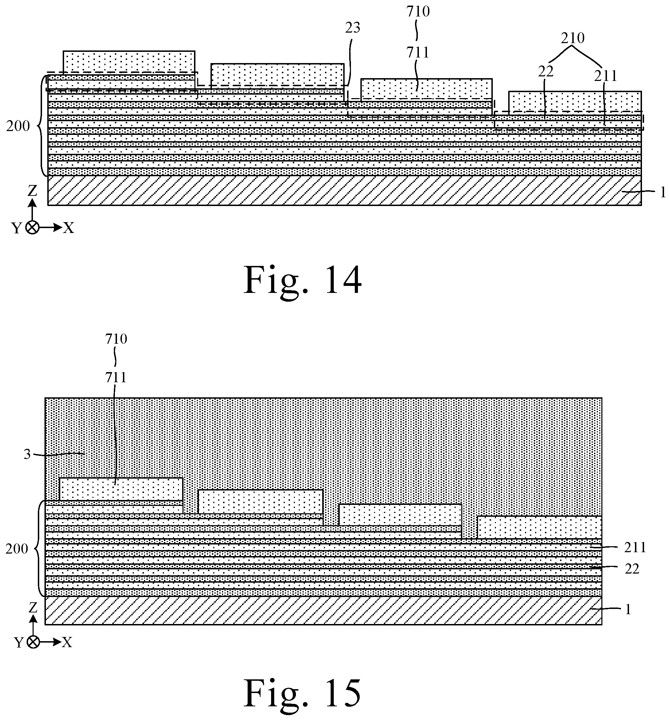

In the above operation, with reference to FIG. 15, during formation of the first cavity C1 and the second cavity C2, the first sacrificial layer 211 is removed using the gate line slit GLS as an etchant channel by means of isotropic etching, so as to form the first cavity C1; and the second sacrificial layer 710 is removed using the gate line slit GLS as an etchant channel by means of isotropic etching, so as to form the second cavity C2. The isotropic etching may adopt selective wet etching or vapor etching. During the wet etching, an etching solution is used as an etchant; and during the vapor etching, an etching gas is used as an etchant.

It is to be noted that when the material of the protective layer 3 and the dielectric layer 22 is silicon oxide and the material of the first sacrificial layer 211 and the second sacrificial layer 710 is silicon nitride, a phosphoric acid solution may be used as an etchant during the wet etching; and at least one of C₄F₈, C₄F₆, and CH₂F₂ may be used as an etching gas during the vapor etching.

S5: With reference to FIGs. 9, 17, and 19, the gate layer 21 is formed in the first cavity C1; and the etch stop layer 7 is formed in the second cavity C2.

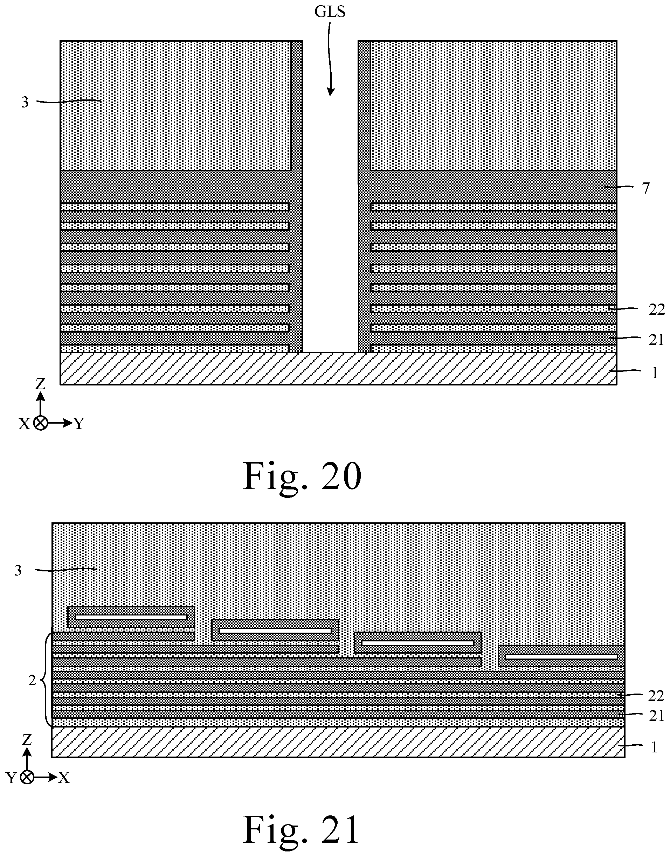

In the above operation, as shown in FIGs. 21 and 22, when an inner wall of the second cavity C2 is covered by a gate material and a gap is retained in the second cavity C2, other processes are required to form the etch stop layer 7, wherein a example process may be referred to the following and is no longer repeated here.

S6: With reference to FIGs. 7, 9, and 23, the isolation structure 8 is formed in the gate line slit GLS.

In the above operation, the isolation structure 8 is formed in the gate line slit GSL, to prevent the shorting between different gate layers 21 in the gate line slit GLS, to prevent the oxidation of the gate layer 21, and to provide the mechanical support function. The isolation structure 8 may be formed in the gate line slit GLS by means of any one of the thin film deposition processes such as CVD, PVD, and ALD.

In some examples, as shown in FIGs. 7 and 23, the isolation structure 8 comprises the first insulation layer 81 and the filling layer 82, wherein the first insulation layer 81 covers the sidewall of the gate line slit GLS and is located between the filling layer 82 and the isolation structure 8, to prevent the shorting between different gate layers 21 in the gate line slit GLS and prevent the oxidization of the gate layer 21; and the filling layer 82 fills the gate line slit GLS to provide the mechanical support function, so as to prevent the collapse of the stack structure 2.

It is to be noted that, the material of the first insulation layer 81 comprises an insulation material. In an example, the material of the first insulation layer 81 comprises silicon oxide, and the present disclosure is not limited thereto. The material of the filling layer 82 may be a conductive material or an insulation material. In an example, the material of the filling layer 82 is a conductive material, and comprises polysilicon, and the present disclosure is not limited thereto. When an array common source doped area is formed in the substrate 1 exposed by the gate line slit GLS, the material of the filling layer 82 may be a conductive material, so as to lead out a source signal through the filling layer 82.

In some other examples, as shown in FIGs. 8 and 29, the isolation structure 8 comprises the second insulation layer 83, the third insulation layer 84, and the filling layer 82. The second insulation layer 83 covers the sidewall of the gate line slit GLS. The third insulation layer 84 is located on a side of the second insulation layer 83 away from the stack structure 2 and between the filling layer 82 and the second insulation layer 83. The filling layer 82 is located on a side of the third insulation layer 84 away from the second insulation layer 83, and fills the gate line slit GLS. It is to be noted that, the material of the second insulation layer 83 comprises silicon nitride, and the present disclosure is not limited thereto. The material of the third insulation layer 84 comprises silicon oxide, and the present disclosure is not limited thereto.

In some examples, before S5, the fabrication method of the semiconductor structure 100 further comprises S10.

S10: The first dielectric layer is formed in the first cavity C1, and the second dielectric layer is formed in the second cavity C2.

In the above operation, the first dielectric layer covers a sidewall of the first cavity C1, and the second dielectric layer covers a sidewall of the second cavity C2, so as to reduce a leakage current of the gate layer 21. The material of the first dielectric layer and the second dielectric layer is a high dielectric constant material. For example, the material of the first dielectric layer and the second dielectric layer comprises at least one of aluminum oxide, hafnium oxide, and tantalum oxide.

In some examples, between S10 and S5, the fabrication method of the semiconductor structure 100 further comprises S11.

S11: The adhesive layer is formed in the first cavity C1.

In the above operation, the adhesive layer is disposed between the second dielectric layer and the gate layer 21, so as to increase the adhesion between the gate layer 21 and the second dielectric layer. The material of the adhesive layer comprises at least one of tantalum, tantalum nitride, titanium, and titanium nitride.

It is to be noted that, an etching rate of the adhesive layer may be close to an etching rate of the gate material, and the adhesive layer may be etched off during a subsequent process of etching for removing the gate material in the second cavity C2.

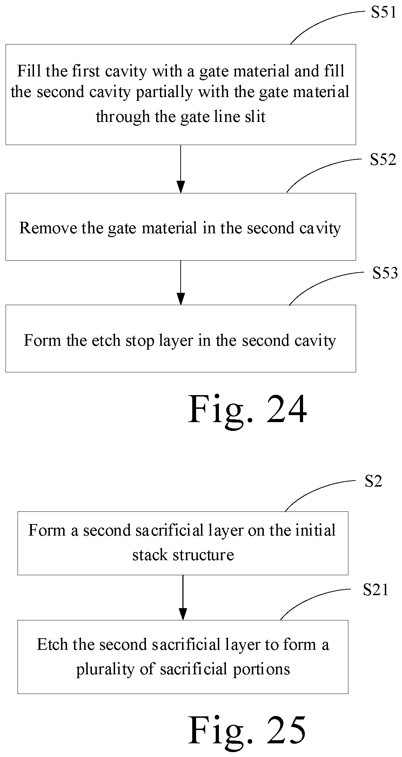

In some examples, with reference to FIG. 25, after S2, the fabrication method of the three-dimensional memory 100 further comprises S21.

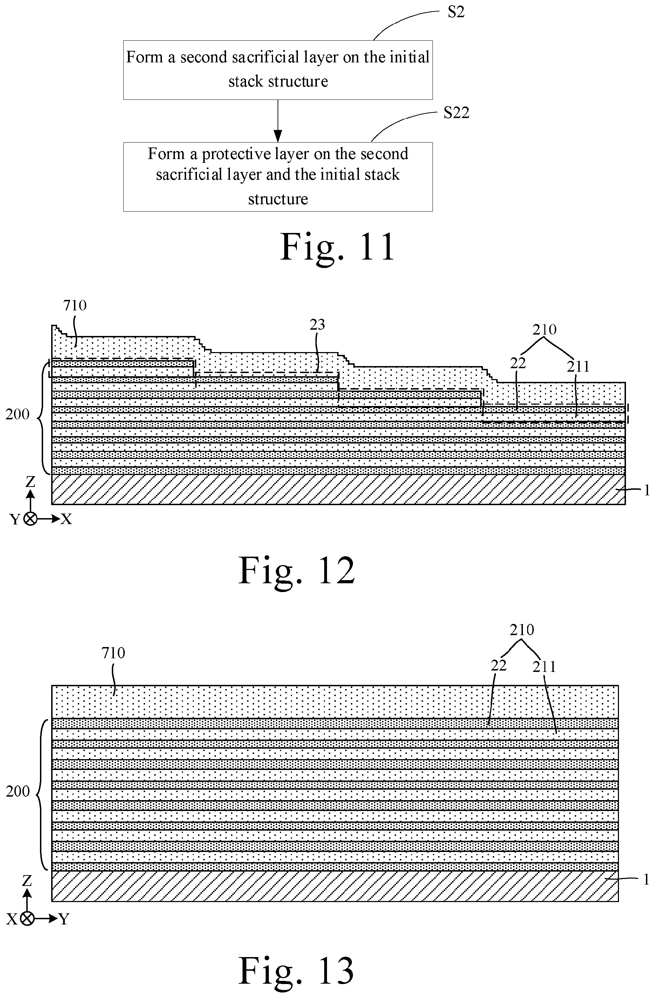

S21: With reference to FIGs. 12, 14, and 25, the second sacrificial layer 710 is etched to form a plurality of sacrificial portions 711.

In the above operation, a sacrificial portion 711 is provided on each initial step 23, and the plurality of sacrificial portions 711 are disposed as being spaced apart from each other. That is, the sacrificial portions 711 on different initial steps 23 are separated from each other, so as to reduce a structural stress, and thus improving reliability.

During patterning of the second sacrificial layer 710, a photoresist layer may be applied on the second sacrificial layer 710, then a patterned photoresist layer is formed through process operations such as exposure and development, the second sacrificial layer 710 is etched using the patterned photoresist layer as a mask, and finally the photoresist layer is removed to form the plurality of sacrificial portions 711.

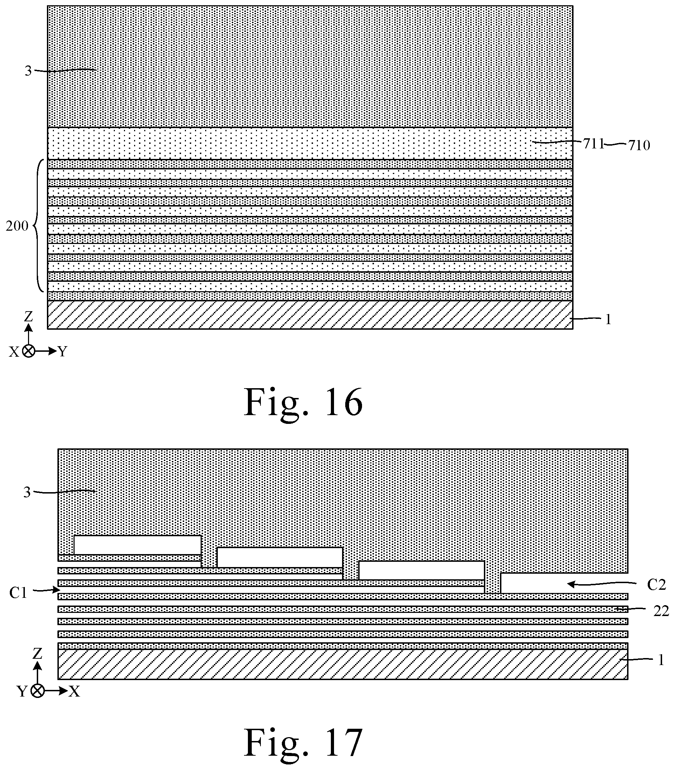

In some examples, with reference to FIGs. 17, 21, and 24, S5 comprises S51-S53.

S51: Through the gate line slit GLS, the first cavity C1 is filled with the gate material and the second cavity C2 is partially filled with the gate material.

In the above operation, the first cavity C1 is fully filled with the gate material, and part of the gate material in the first cavity C1 forms the gate layer 21; and a gap is retained in the second cavity C2. The thickness of the second cavity C2 is greater than the thickness of the first cavity C1. At this time, a filling duration of the gate material may be controlled, such that when the first cavity C1 is fully filled with the gate material so as to form the gate layer 21, the filling of the gate material is stopped, an inner wall of the second cavity C2 is covered by the gate material, and the gap is retained in the second cavity C2.

S52: The gate material in the second cavity C2 is removed.

In the above operation, during a process of removing the gate material covering the sidewall of the gate line slit GLS, the gate material covering the sidewall of the gate line slit GLS is also removed. That is, the removal of the gate material covering the sidewall of the gate line slit GLS and the removal of the gate material in the second cavity C2 may be performed in the same process. For example, the gate material on the sidewall of the gate line slit GLS and the gate material in the second cavity C2 are removed by means of a single etching process.

Since the gate material in the second cavity C2 retains the gap, during the process of removing the gate material on the sidewall of the gate line slit GLS, the etchant enters the gap in the second cavity C2 and contacts the gate material in the second cavity C2 over a large area for etching, and after the gate material on the sidewall of the gate line slit GLS is removed, the gate material in the second cavity C2 is also removed. Here, the etching duration may be controlled such that both the gate material covering the sidewall of the gate line slit GLS and the gate material in the second cavity C2 are removed completely.

S53: The etch stop layer 7 is formed in the second cavity C2.

In some examples, S53 comprises S531.

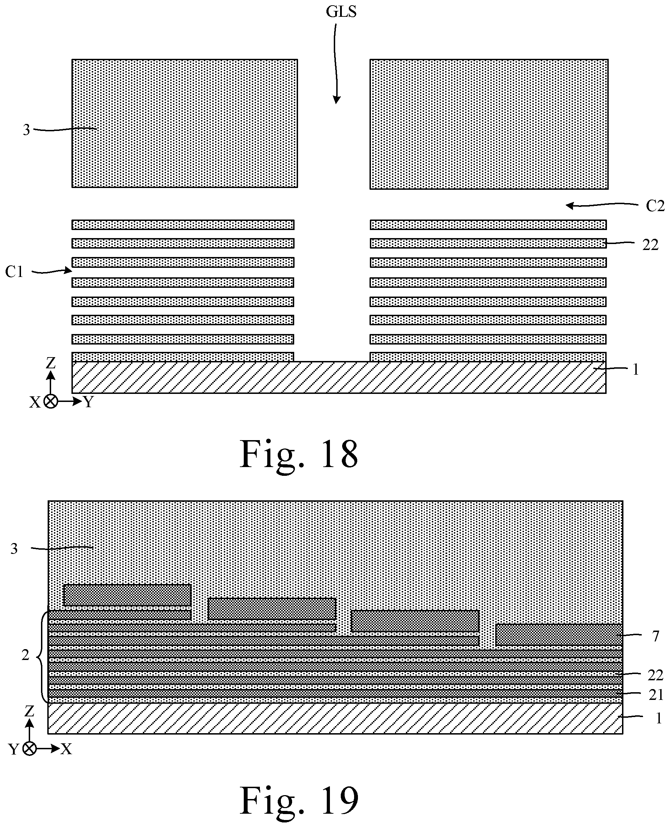

S531: With reference to FIGs. 19 and 29, the second cavity C2 is filled with a dielectric material through the gate line slit GLS.

In the above operation, with reference to FIGs. 19 and 20, the dielectric material fills the second cavity C2 to form the etch stop layer 7. The dielectric material covers the sidewall of the gate line slit GLS to form the second insulation layer 83 of the isolation structure 8 (referring to FIG. 8). The dielectric material is an insulation material.

During filling of the dielectric material in the second cavity C2, the gate line slit GLS may be used as a deposit channel to fill the second cavity C2 with the dielectric material by means of any one of the thin film deposition processes such as CVD, PVD, and ALD. During a process of filling the second cavity C2 with the dielectric material using the gate line slit GLS as the deposit channel, the dielectric material is also formed on the sidewall of the gate line slit GLS.

It is to be noted that the material of the protective layer 3 has a high etch selectivity ratio with respect to the dielectric material, to ensure that an initial contact hole 61 (referring to FIG. 32) may be stopped on the etch stop layer 7 formed by the dielectric material during subsequent removal of the protective layer 3 for forming the contact hole 6 (referring to FIG. 33), thereby ensuring that almost no etch stop layer 7 is removed. It is to be understood that the above-described initial contact hole 61 (referring to FIG. 32) may also penetrate through the protective layer 3 and extend to stop in the etch stop layer 7 formed by the dielectric material.

In some other examples, with reference to FIG. 28, S53 comprises S532 and S533.

S532: With reference to FIGs. 19, 28, and 29, the second cavity C2 is filled with a semiconductor material through the gate line slit GLS.

In the above operation, with reference to FIGs. 19 and 20, during filling of the semiconductor material in the second cavity C2, the gate line slit GLS may be used as a deposit channel to fill the second cavity C2 with the semiconductor material by means of any one of the thin film deposition processes such as CVD, PVD, and ALD. During a process of filling the second cavity C2 with the semiconductor material using the gate line slit GLS as a deposit channel, the semiconductor material is also formed on the sidewall of the gate line slit GLS.

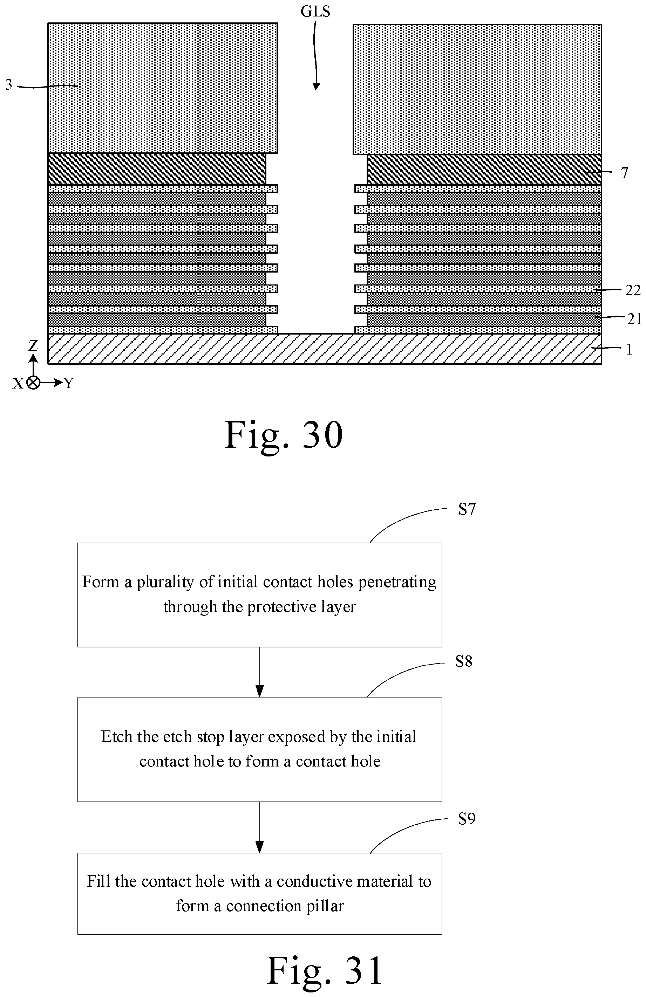

S533: With reference to FIGs. 28 and 30, the semiconductor material covering the sidewall of the gate line slit GSL is removed.

In the above operation, the semiconductor material on the sidewall of the gate line slit GLS may be etched off using an etchant, and an etching duration may be controlled such that the etching is stopped after the semiconductor material on the sidewall of the gate line slit GLS is etched off. At this time, the semiconductor material may be a material different from the material of the protective layer 3, as along as the material of the protective layer 3 has a high etch selectivity ratio with respect to the semiconductor material. In an example, the semiconductor material comprises at least one of polysilicon or metal, and the present disclosure is not limited thereto.

In some examples, the fabrication method further comprises S22.

S22: With reference to FIGs. 11, 15, and 16, the protective layer 3 is formed on the second sacrificial layer 710 and the initial stack structure 200.

In the above operation, the protective layer 3 covers the initial stack structure 200 and the second sacrificial layer 710. The protective layer 3 may also fill the step area B by means of any one of the thin film deposition processes such as CVD, PVD, and ALD (referring to FIG. 3) and be formed by means of a planarization process. The planarization process comprises chemical mechanical planarization (CMP) process or recess etch process (REP), and the present disclosure is not limited thereto.

It is to be noted that the material of the protective layer 3 is different from materials of both the first sacrificial layer 211 and the second sacrificial layer 710. The material of the protective layer 3 comprises an insulation material and may be the same as the material of the dielectric layer 22. In an example, the material of the protective layer 3 comprises silicon oxide. For example, the material of the protective layer 3 comprises silicon dioxide, and the present disclosure is not limited thereto.

In some examples, after the etch stop layer 7 is formed, with reference to FIG. 31, the fabrication method of the semiconductor structure 100 further comprises S7-S9.

S7: With reference to FIGs. 31 and 32, a plurality of initial contact holes 61 penetrating through the protective layer 3 are formed.

In the above operation, each initial contact hole 61 corresponds to one step 23, and the initial contact hole 61 is located on the corresponding step 23. Here, the step 23 comprises the gate layer 21 and the dielectric layer 22.

The initial contact hole 61 may be formed by means of dry etching or a combination of dry etching and wet etching processes. In an example, the initial contact hole 61 is formed using an anisotropic etching (any one of dry etching such as ion milling etching, plasma etching, reactive ion etching, laser ablation, etc.) process, and an etching duration is controlled such that the etching is stopped at the etch stop layer 7 after penetrating through the protective layer 3. It is to be noted that the initial contact hole 61 may extend to stop in the etch stop layer 7.

S8: With reference to FIGs. 31, 32, and 33, the etch stop layer 7 exposed by the initial contact hole 61 is etched to form the contact hole 6.

In the above operation, each contact hole 6 corresponds to one step 23, and an orthographic projection of the contact hole 6 on the substrate 1 is located within an orthographic projection of the corresponding step 23 on the substrate 1.

It is to be noted that the shape of the contact hole 6 may be cylindrical. For example, the shape of the contact hole 6 is cylindrical or prismatic, and the present disclosure is not limited thereto.

S9: With reference to FIGs. 5, 31, and 33, the contact hole 6 is filled with a conductive material to form the connection pillar 5.

In the above operation, the connection pillar 5 is electrically connected with the gate layer 21 of the corresponding step 23. Here, the contact hole 6 is filled with the conductive material by any one of the thin film deposition processes such as CVD, PVD, and ALD. The gate layer 21 is electrically connected with a corresponding signal line through the connection pillar 5. The signal line comprises at least one of a string selection line (one of SSL1 to SSL4), the ground selection line GSL, and the word line (one of WL1 to WL4).

It is to be noted that the shape of the connection pillar 5 may be cylindrical. For example, the shape of the connection pillar 5 is cylindrical or prismatic, and the present disclosure is not limited thereto.

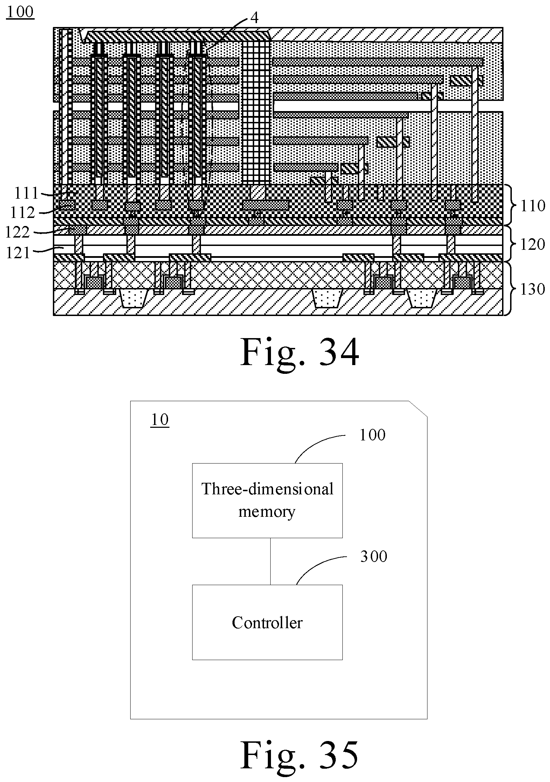

With reference to FIG. 34, the three-dimensional memory 100 further comprises an array interconnection layer 110, a peripheral interconnection layer 120, and a peripheral circuit 130.

The array interconnection layer 110 may be coupled with the memory cell string 4. The array interconnection layer 110 may comprise one or more first interlayer insulation layers 111, and may further comprise a plurality of contacts insulated from each other through these first interlayer insulation layers 111, wherein the contacts comprise, for example, a bit line contact coupled with the bit line, and a drain selection gate contact coupled with a drain selection gate. The array interconnection layer 110 may further comprise one or more first interconnection conductor layers 112. The first interconnection conductor layer 112 may comprise a plurality of connection lines, e.g., the bit line, and the word line connection line coupled with the word line. A material of the first interconnection conductor layer 112 and the contact may be a conductive material, which is, for example, one or a combination of several of tungsten, cobalt, copper, aluminum, and metal silicides, or other suitable materials. A material of the first interlayer insulation layer 111 is an insulation material, which is, for example, one or a combination of several of silicon oxide, silicon nitride, and a high dielectric constant insulation material, or other suitable materials.

The peripheral circuit 130 is configured to control and sense an array device. The peripheral circuit 130 may be any suitable digital, analog and/or hybrid signal control and sensing circuit configured to support operations (or working) of the array device, including, but not limited to, a page buffer, a decoder (e.g., a row decoder and a column decoder), a sense amplifier, a driver (e.g., a word line driver), a charge pump, a current or voltage reference, or any active or passive components (e.g., a transistor, a diode, a resistor or a capacitor) of a circuit. The peripheral circuit may further comprise any other circuits compatible with an advanced logic process, including a logic circuit (e.g., a processor and a programmable logic device (PLD)), or a memory circuit (e.g., a static random-access memory (SRAM)).

The peripheral interconnection layer 120 is coupled with the peripheral circuit 130 to achieve transmission of an electrical signal between the peripheral circuit 130 and the peripheral interconnection layer 120. The peripheral interconnection layer 120 may comprise one or more second interlayer insulation layers 121, and may further comprise one or more second interconnection conductor layers 122. Different second interconnection conductor layers 122 may be coupled through contacts. A material of the second interconnection conductor layer 122 and the contact may be a conductive material, which is, for example, one or a combination of several of tungsten, cobalt, copper, aluminum, and metal silicides, or other suitable materials. A material of the second interlayer insulation layer 121 is an insulation material, which is, for example, one or a combination of several of silicon oxide, silicon nitride, and a high dielectric constant insulation material, or other suitable materials.

The peripheral interconnection layer 120 may be coupled with the array interconnection layer 110, such that the memory cell string 4 may be coupled with the peripheral circuit. In an example, since the peripheral interconnection layer 120 is coupled with the array interconnection layer 110, the peripheral circuit 130 may be coupled with the memory cell string 4, so as to achieve transmission of an electrical signal between the peripheral circuit 130 and the memory cell string 4. An adhesion interface may be disposed between the peripheral interconnection layer 120 and the array interconnection layer 110, wherein the peripheral interconnection layer 120 and the array interconnection layer 110 may be adhered and coupled with each other through the adhesion interface.

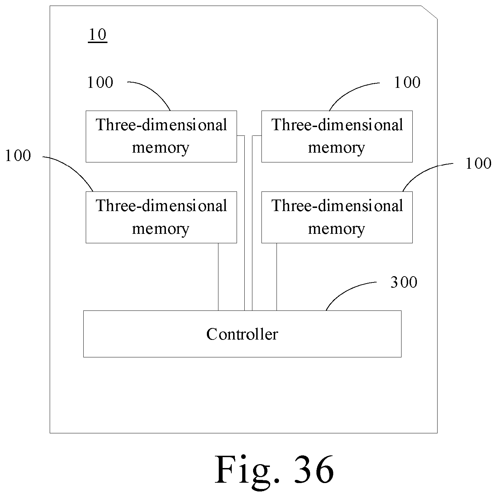

FIG. 35 is a block diagram of a memory system 10 according to some examples. FIG. 36 is a block diagram of the memory system 10 according to some other examples. As shown in FIGs. 35 and 36, some examples of the present disclosure further provide a memory system 10. The memory system 10 comprises a controller 300 and the three-dimensional memory 100 of some examples above, wherein the controller 300 is coupled to the three-dimensional memory 100 to control the three-dimensional memory 100 to store data.

The memory system 10 may be integrated into various types of storage apparatuses, for example, be comprised in the same package (such as a universal flash storage (UFS) package or an embedded multi media card (eMMC) package). That is, the memory system 10 may be applied to and packaged into different types of electronic products, such as a mobile phone, a desktop computer, a laptop computer, a tablet computer, a vehicle computer, a game console, a printer, a positioning apparatus, a wearable electronic apparatus, a smart sensor, a virtual reality (VR) apparatus, an augmented reality (AR) apparatus, or any other suitable electronic apparatuses having storage therein.

In some examples, with reference to FIG. 35, the memory system 10 comprises the controller 300 and one three-dimensional memory 100, and may be integrated into a memory card.

The memory card comprises any one of a PC (PCMCIA, Personal Computer Memory Card International Association) card, a compact flash (CF) card, a smart media (SM) card, a memory stick, a multimedia card (MMC), a secure digital memory card (SD), and a UFS.

In some other examples, with reference to FIG. 36, the memory system 10 comprises the controller 300 and a plurality of three-dimensional memories 100, and is integrated into a solid state drive (SSD).

Some examples of the present disclosure further provide an electronic apparatus. The electronic apparatus may be any one of a mobile communication terminal, a tablet, a game console, a digital multimedia player, a smart wearable apparatus (such as a smart watch, a smart bracelet, or smart glasses), etc.

The electronic apparatus may comprise the memory system 10 as described above, and may further comprise at least one of a central processing unit (CPU) and a cache, etc.

It may be understood that beneficial effects that can be achieved by the fabrication method of the three-dimensional memory 100, the memory system 10, and the electronic apparatus provided by the above examples of the present disclosure may be referred to the beneficial effects of the three-dimensional memory 100 above, which are no longer repeated here.

The above descriptions are merely example implementations of the present disclosure, and the protection scope of the present disclosure is not limited to thereto. Any variation or replacement that may be readily figured out by those skilled in the art within the technical scope disclosed by the present disclosure shall be encompassed within the protection scope of the present disclosure. Therefore, the protection scope of the present disclosure shall be defined by the protection scope of the claims.

## Claims

1. A three-dimensional memory, comprising:
a stack structure comprising a gate layer and a dielectric layer disposed alternately and comprising a plurality of steps;
an etch stop layer disposed on the plurality of steps;
a protective layer covering the stack structure and the etch stop layer; and
a plurality of connection pillars, wherein each of the connection pillars penetrates through the protective layer and the etch stop layer on a corresponding step and is connected with the gate layer of the corresponding step.

2. The three-dimensional memory of claim 1, wherein the etch stop layer comprises a plurality of etch stop portions, the etch stop portion is provided on each of the steps, and the plurality of etch stop portions are disposed as being spaced apart from each other.

3. The three-dimensional memory of claim 1, wherein the etch stop layer is a continuous film layer covering the plurality of steps.

4. The three-dimensional memory of claim 3, wherein the etch stop layer comprises an insulation material.

5. The three-dimensional memory of claim 2, further comprising:
an isolation structure penetrating through the stack structure and the protective layer and comprising a first insulation layer, wherein a material of the first insulation layer is different from that of the etch stop layer.

6. The three-dimensional memory of claim 5, wherein the isolation structure further comprises a filling layer, and the first insulation layer is located between the filling layer and the stack structure.

7. The three-dimensional memory of claim 5, wherein the material of the etch stop layer comprises silicon nitride or polysilicon.

8. The three-dimensional memory of claim 2, further comprising:
an isolation structure penetrating through the stack structure and the protective layer and comprising a second insulation layer, wherein a material of the second insulation layer is the same as that of the etch stop layer.

9. The three-dimensional memory of claim 8, wherein the isolation structure further comprises a filling layer, and the second insulation layer is located between the filling layer and the stack structure.

10. The three-dimensional memory of claim 9, wherein the isolation structure further comprises a third insulation layer located between the filling layer and the second insulation layer.

11. The three-dimensional memory of claim 8, wherein the material of the second insulation layer and the etch stop layer comprises silicon nitride.

12. The three-dimensional memory of any one of claims 1-11, wherein a thickness of the etch stop layer is greater than a thickness of the gate layer.

13. A three-dimensional memory, comprising:
a stack structure comprising a gate layer and a dielectric layer disposed alternately and comprising a plurality of steps;
an insulation layer disposed on the plurality of steps;
a protective layer covering the stack structure and the insulation layer; and
a plurality of connection pillars, wherein each of the connection pillars penetrates through the protective layer and the insulation layer on a corresponding step and is connected with the gate layer of the corresponding step.

14. The three-dimensional memory of claim 13, wherein the insulation layer is a continuous film layer covering the plurality of steps.

15. The three-dimensional memory of claim 13, wherein a material of the insulation layer comprises silicon nitride.

16. The three-dimensional memory of any one of claims 13-15, wherein a thickness of the insulation layer is greater than a thickness of the gate layer.

17. A fabrication method of a three-dimensional memory, comprising:
forming an initial stack structure comprising a first sacrificial layer and a dielectric layer disposed alternately and comprising a plurality of initial steps;
forming a second sacrificial layer on the initial stack structure;
forming a gate line slit penetrating through the second sacrificial layer and the initial stack structure, and removing the first sacrificial layer to form a first cavity and removing the second sacrificial layer to form a second cavity through the gate line slit;
forming a gate layer in the first cavity;
forming an etch stop layer in the second cavity; and
forming an isolation structure in the gate line slit.

18. The fabrication method of claim 17, further comprising:
after forming the second sacrificial layer on the initial stack structure, etching the second sacrificial layer to form a plurality of sacrificial portions, wherein one of the sacrificial portions is provided on each of the initial steps, and the plurality of sacrificial portions are disposed as being spaced apart from each other.

19. The fabrication method of claim 17 or 18, wherein the forming the gate layer in the first cavity and forming the etch stop layer in the second cavity comprise:
filling the first cavity with a gate material and filling the second cavity partially with the gate material through the gate line slit;
removing the gate material in the second cavity; and
forming the etch stop layer in the second cavity.

20. The fabrication method of claim 19, wherein the forming the etch stop layer in the second cavity comprises: filling the second cavity with a dielectric material through the gate line slit, wherein the dielectric material in the second cavity forms the etch stop layer.

21. The fabrication method of claim 19, wherein the forming the etch stop layer in the second cavity comprises:
filling the second cavity with a semiconductor material through the gate line slit; and
removing the semiconductor material covering a sidewall of the gate line slit, to form the etch stop layer.

22. The fabrication method of claim 19, further comprising:
before forming the gate layer in the first cavity and forming the etch stop layer in the second cavity, forming a first dielectric layer in the first cavity, and forming a second dielectric layer in the second cavity, wherein the first dielectric layer covers a sidewall of the first cavity, and the second dielectric layer covers a sidewall of the second cavity.

23. The fabrication method of claim 17, further comprising:
forming a protective layer covering the initial stack structure and the second sacrificial layer, wherein the gate line slit also penetrates through the protective layer.

24. The fabrication method of claim 23, further comprising:
forming a plurality of initial contact holes penetrating through the protective layer;
etching the etch stop layer exposed by the initial contact hole, to form a contact hole; and
filling the contact hole with a conductive material to form a connection pillar, wherein the connection pillar is electrically connected with the gate layer of the corresponding step.

25. A memory system, comprising:
a controller, and
a three-dimensional memory, wherein the three-dimensional memory is the three-dimensional memory of any one of claims 1-16, and the controller is coupled to the three-dimensional memory to control the three-dimensional memory to store data.

26. An electronic apparatus, comprising the memory system of claim 25.
